# NEUE EUROPÄISCHE PATENTSCHRIFT

(11) **EP 1 763 686 B2**
(45) Veröffentlichungstag und Bekanntmachung des Hinweises auf die Entscheidung über den Einspruch: **18.06.2014**
(45) Hinweis auf die Patenterteilung: 26.05.2010
(21) Anmeldenummer: 05757029.3
(22) Anmeldetag: 01.07.2005
(51) Int. Cl.: G01V 3/08, G01R 33/022

(54) **ANORDNUNG ZUM BETREIBEN EINES GEOPHYSIKALISCHEN ORTUNGSGERÄTES**
ARRANGEMENT FOR OPERATING A GEOPHYSICAL LOCATING UNIT
SYSTEME POUR ACTIONNER UN APPAREIL DE LOCALISATION GEOPHYSIQUE

(30) Priorität: 02.07.2004 DE 102004032234; 09.12.2004 DE 102004059199
(43) Veröffentlichungstag der Anmeldung: 21.03.2007
(73) Patentinhaber: OKM ORTUNGSTECHNIK KRAUSS & MÜLLER GMBH, *, 04603 Windischleuba (DE)
(72) Erfinder: KRAUSS, Andreas, 04617 Fockendorf (DE)
(74) Vertreter: Kruspig, Volkmar
(86) Internationale Anmeldenummer: PCT/EP2005/007117
(87) Internationale Veröffentlichungsnummer: WO 2006/002946

(56) Entgegenhaltungen:
- DE-A1- 2 408 547
- DE-A1- 2 942 847
- DE-A1- 3 102 802
- DE-A1- 4 232 466
- DE-U1- 9 213 051
- DE-U1- 20 118 655
- DE-U1- 29 805 631
- GB-A- 2 236 399
- US-A- 3 040 248
- US-A- 3 781 664
- US-A- 4 427 943
- US-A- 5 321 361
- US-A- 5 537 038
- US-A- 5 902 238
- 'Logarithmic amplifier for bipolar signals with a large dynamic range' MEASUREMENT TECHNIQUES Bd. 22, Nr. 8, 01 August 1979,
- 'Logarithmic amplifier for small direct currents' MEASUREMENT TECHNIQUES Bd. 40, Nr. 1, 01 Januar 1971,
- PAUL HOROWITZ, WINFRIED HILL THE ART OF ELECTRONIC 1989, CAMBRIDGE UNIVERSITY PRESS, 22ND PRINTING 2008, Seiten 212 - 217

## Beschreibung

Die Erfindung betrifft eine Anordnung zum Betreiben eines geophysikalischen Ortungsgeräts mittels Auswertung von Magnetfeldänderungen, umfassend Flux-Gate-Sensoren, eine Verstärkerschaltung sowie eine Bewertungs- und Anzeigeeinheit gemäß Oberbegriff des Patentanspruchs 1.

Geophysikalische Ortungsgeräte auf der Basis der Erfassung von Magnetfeldänderungen bzw. Magnetfeldanomalien gehören zum Stand der Technik.

Bei derartigen Geräten wird eine magnetfeldselektive Sensorik, z.B. ein Flux-Gate verwendet, wobei auswerteseitig eine Verstärkung der detektierten Signale erfolgt und die verstärkten Signale auf eine Anzeigeeinheit gelangen. Beim Abschreiten eines bestimmten Suchareals werden einlaufende Signale gespeichert und zeilen- bzw. spaltenweise aufbereitet, um mikroprozessorunterstützt eine bildliche Darstellung des Untergrunds zu erreichen.

Bei einer einfachen Verstärkung von Flux-Gates-Signalen besteht ein wesentlicher Nachteil darin, dass eine auswertbare Messung nur bei sehr kleinen Feldern bzw. Feldänderungen erfolgen kann, und zwar aufgrund der hohen notwendigen Verstärkung beim Einsatz derartiger Sensoren.
Liegen stärkere Magnetfelder, z.B. in Form von Störfeldern vor, besteht die Gefahr, dass der eingesetzte Verstärker übersteuert wird. Aufgrund dieser Übersteuerung ist dann eine Feldänderung, welche für die eigentliche Ortungsaufgabe zu bestimmen ist, nicht mehr erfassbar. Eine naheliegende Möglichkeit besteht darin, die Verstärkung regelbar auszugestalten, wobei hieraus jedoch folgt, dass sehr kleine Magnetfeldänderungen dann nicht mehr oder nur mit sehr großem Aufwand aufgelöst werden können.

Dokument US-A-5,902,238 offenbart eine Vorrichtung zur Lokalisierung eines medizinischen Schlauches. Die Vorrichtung weist zwei Magnetfeldsensoren auf, die als Flux-Gate-Sensoren ausgebildet sein können. Die Sensorsignale werden von jeweils einem Verstärker verstärkt und dann von jeweils einem Integrator integriert. Ein Differenzverstärker erhält an seinen Eingängen die verstärkten und integrierten Sensorsignale.

Aus dem Vorgenannten ist es daher Aufgabe der Erfindung, eine weiterentwickelte Anordnung zum Betreiben eines geophysikalischen Ortungsgeräts auf der Basis der Auswertung von Magnetfeldänderungen anzugeben, wobei die Anordnung unter Verzicht auf eine aufwendige Verstärkungsregelung in der Lage sein soll, sowohl erhebliche Magnetfeldgradienten zu erkennen, als auch kleine Magnetfeldänderungen zur optimalen Ortung auch kleinerer oder in größerer Tiefe liegender Gegenstände zu erfassen.

Die Lösung der Aufgabe der Erfindung erfolgt mit einer Anordnung gemäß der Merkmalskombination nach Patentanspruch 1, wobei die Unteransprüche mindestens zweckmäßige Ausgestaltungen und Weiterbildungen beinhalten.

Die erfindungsgemäße Anordnung geht von der Auswertung einer Magnetfelddifferenz aus, wobei als Sensoren zwei beabstandete, in gleicher Richtung orientiere Flux-Gate-Elemente vorgesehen sind.
Aufgrund der Anordnung der Flux-Gates in derselben Richtung liefern diese dem Vorzeichen nach gleiche Ausgangsspannungen, wobei der absolute Wert der Ausgangsspannung unterschiedlich ist, da das Magnetfeld mit wachsender Entfernung abnimmt.

Durch die Anordnung der Flux-Gate-Sensoren beabstandet, in gleicher Richtung, und zwar in einer abgesetzten Sonde, und die Verwendung eines Differenzverstärkers ist es möglich, nahezu unabhängig von der absoluten Stärke des Magnetfelds eine Änderung desselben nachweisbar zu machen, und zwar auch dann, wenn die Magnetfeldänderung selbst sehr gering ist.

Die Ausgangssignale der Flux-Gate-Sensoren werden erfindungsgemäß auf je eine Pegelanpassschaltung sowie je einen Tiefpass geführt, wobei ausgangsseitig der Tiefpassschaltungen diese je auf einen Eingang des Differenzverstärkers gelangen, welcher wiederum mit dem Eingang eines Begrenzerverstärkers in Verbindung steht.

Am Ausgang des Begrenzerverstärkers liegt dann das Auswertesignal zur weiteren Verarbeitung an.

Bevorzugt werden die Flux-Gate-Sensoren über eine Spannungsstabilisierungsschaltung betrieben.

Zum Abgleich bzw. zum Kalibrieren der Anordnung ist eine niederohmige Referenzspannungsquelle vorgesehen, die mit dem Referenzeingang des Differenzverstärkers in Verbindung steht.

Die Verbindungsleitungen zwischen den Flux-Gate-Sensoren und dem Eingang der Pegelanpassschaltung sind bevorzugt geschirmt ausgeführt.

Für einen optimalen Betrieb wird das Ausgangssignal bei nicht vorhandenem Magnetfeld in etwa auf die Hälfte der Betriebsspannung der Flux-Gate-Sensoren eingestellt.

Im Rückkopplungszweig des Begrenzerverstärkers ist bei der Erfindung eine Parallelschaltung eines Widerstands und einer Diodengruppe vorgesehen.
Die Diodengruppe besteht vorzugsweise aus mindestens zwei antiparallel geschalteten Dioden.

Die Erfindung soll nachstehend anhand eines Ausführungsbeispiels sowie unter Zuhilfenahme einer Figur näher erläutert werden.

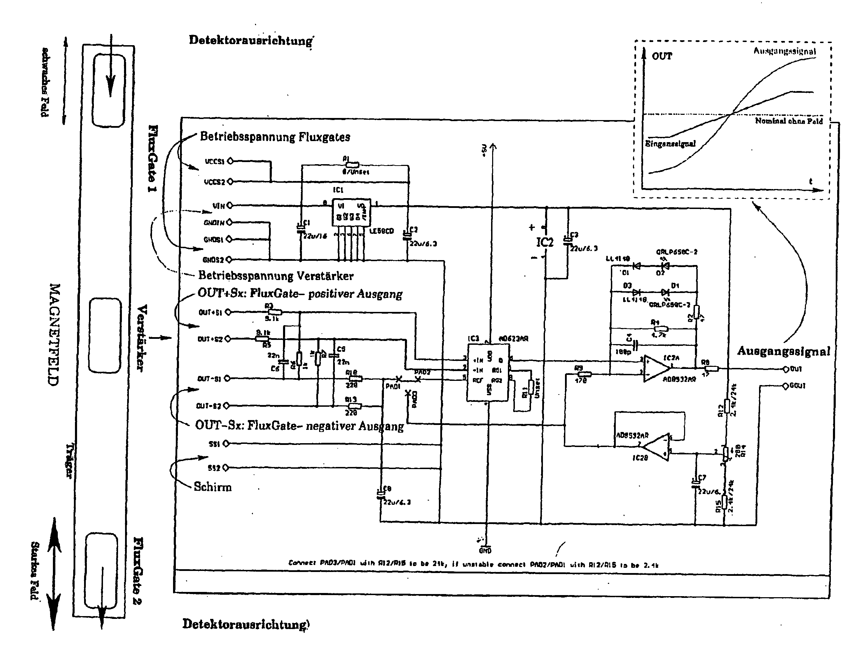

Die Figur zeigt hierbei ein Prinzipschaltbild mit angedeuteter Anordnung der Flux-Gate-Sensoren in der Sonde und einen typischen Verlauf von Eingangs- und Ausgangssignal als Diagramm.

Gemäß der Darstellung im linken Bildteil der Figur befindet sich auf einem Träger eine beabstandete Anordnung, umfassend ein Flux-Gate 1 sowie ein weiteres Flux-Gate 2. Mit den vertikalen Pfeildarstellungen im linken Randteil des Figur ist einerseits ein schwaches, andererseits ein stärkeres Magnetfeld symbolisiert. Die innerhalb der Flux-Gates befindliche Pfeildarstellung symbolisiert die Ausrichtung der Detektoren.

Die Ausgangssignale von Flux-Gate 1 und Flux-Gate 2 gelangen auf je einen Eingang einer Verstärkerschaltung.

Diese Verstärkerschaltung umfasst zunächst eine Pegelanpassbaugruppe sowie eine Tiefpassschaltung.

Konkret werden die Ausgangssignale der Flux-Gates 1 bzw. 2 an OUT+Sx und OUT-Sx angeschlossen. Die OUT-Sx-Ausgänge liefern in etwa die halbe Betriebsspannung.

Die Kombination aus Widerstand R3 und R6 sowie Kondensator C6 sowie Widerstand R5, R7 und Kondensator C5 bilden die vorerwähnte Pegelanpassungsschaltung und filtern höherfrequente Signalanteile aus. Das derart vorverarbeitete Signal gelangt dann auf den Eingang 2 bzw. 3 des Differenzverstärkers IC3.

Die PADX-Anschlüsse und Verbindungen dienen der Einstellung der Ausgangsspannung des gesamten Verstärkers bei nicht vorhandenem Feld. Üblicherweise ist PAD1 mit PAD2 verbunden, wobei die Ausgangsspannung bei nicht vorhandenem Feld mit dem Potentiometer R14 in etwa um die halbe Betriebsspannung einzustellen ist.

Der Schaltkreis IC2B stellt eine entsprechende Referenzspannung niederohmig zur Verfügung.

Der Verstärker IC2A ist als Begrenzerverstärker ausgeführt, wobei eine Rückkopplung über die Dioden D1 bis D4 in Verbindung mit den Widerständen R2 und R4 erfolgt.
Durch diese Maßnahme wird erreicht, dass kleine Ausgangsspannungen mehr verstärkt werden als größere Spannungen, wobei zu beachten ist, dass die Eingangsspannung an IC2A bereits die Differenz der Flux-Gate-Ausgangssignale darstellt.

Das Ausgangssignal wird zur weiteren Verarbeitung an OUT mit Bezug zu GOUT abgegriffen.
Die Pins VCCSx und GNDSx sind die Betriebsspannungsanschlüsse für die Flux-Gates. VIN und GNDIN stellen die Betriebsspannungsanschlüsse für den Verstärker dar, wobei eine optionale Stabilisierung mit Hilfe des Schaltkreises IC1 möglich ist. Wenn eine Bestückung der Schaltung mit R1 erfolgt, dann entfällt die Stabilisierung.

Die Anschlüsse SSx bilden den Schirm für die Zuleitungen zu den Flux-Gate-Sensoren 1 bzw. 2.

Mit Hilfe der vorstehend beschriebenen Schaltungsanordnung kann in Verbindung mit der Sonde, welche zwei beabstandete, in gleicher Richtung orientierte Flux-Gates-Sensoren aufweist, eine effektive und reproduzierbare Erfassung von Magnetfeldänderungen für die Ortung erfolgen, und zwar im wesentlichen unabhängig von dem Betrag des Magnetfelds selbst.

## Patentansprüche

1. Anordnung zum Betreiben eines geophysikalischen Ortungsgeräts mittels Auswertung von Magnetfeldänderungen, umfassend eine Sonde und Flux-Gate-Sensoren, eine Verstärkerschaltung sowie eine Bewertungs- und Anzeigeeinheit,
wobei:
- in der Sonde zwei beabstandete, in gleicher Richtung orientierte Flux-Gate-Sensoren befindlich sind, und die Sensoren von der Polarität gleiche Ausgangsspannungen liefern,
- die Ausgangssignale auf je eine Pegelanpassschaltung sowie je einen Tiefpass geführt sind,
- ausgangsseitig der Tiefpassschaltungen diese je auf einen Eingang eines Differenzverstärkers gelangen, welcher mit dem Eingang eines Begrenzerverstärkers in Verbindung steht,
- im Rückkopplungszweig des Begrenzerverstärkers eine Parallelschaltung eines Widerstands und einer Diodengruppe mit den Dioden D1 bis D4 vorgesehen ist, wobei eine Rückkopplung über die Dioden D1 bis D4 in Verbindung mit Widerständen R2 und R4 erfolgt, derart, dass kleine Ausgangspannungen mehr verstärkt werden als größere Spannungen und
- am Ausgang des Begrenzerverstärkers das Auswertesignal zur weiteren Verarbeitung anliegt.

2. Anordnung nach Anspruch 1,
**dadurch gekennzeichnet, dass**
eine Spannungsstabilisierungsschaltung für die Stromversorgung der Flux-Gate-Sensoren vorgesehen ist.

3. Anordnung nach Anspruch 1 oder 2,
**dadurch gekennzeichnet, dass**
zum Abgleich der Anordnung eine niederohmige Referenzspannungsquelle mit dem Referenzeingang des Differenzverstärkers verbindbar ist.

4. Anordnung nach einem der vorangegangenen Ansprüche,
**dadurch gekennzeichnet, dass**
die Verbindungsleitungen zwischen den Flux-Gate-Sensoren und dem Eingang der Pegelanpassschaltung geschirmt ausgeführt sind.

5. Anordnung nach einem der vorangegangenen Ansprüche,
**dadurch gekennzeichnet, dass**
das Ausgangssignal bei nicht vorhandenem Magnetfeld auf die Hälfte der Betriebsspannung der Flux-Gate-Sensoren eingestellt und kalibriert ist.

6. Anordnung nach Anspruch 1,
**dadurch gekennzeichnet, dass**
die Diodengruppe aus mindestens zwei antiparallel geschalteten Dioden (D1, D3; D2, D4) besteht.

## Claims

1. An arrangement for operating a geophysical locator device through evaluating changes of a magnetic field, the arrangement comprising a probe and fluxgate sensors, an amplifier circuit and an evaluation- and display unit, wherein
- two offset fluxgate sensors, which are oriented in the same direction, are disposed in the probe, and the sensors supply output voltages with the same polarity;
- the output signals are fed to one respective level adaptation circuit each, and to one respective low pass each;
- the output signals are fed to one respective input of a differential amplifier each on the output sides of the low pass circuits, the differential amplifier connected with an input of a limiting amplifier;
- a parallel circuit with a resistor and a diode group with diodes D1 to D4 is provided in a feedback path of the limiting amplifier, whereby feedback ensues with diodes D1 to D4 together with resistors R2 and R4 so that small output voltages are amplified more than larger output voltages; and
- the output signal is provided at the output of the limiting amplifier for further processing.

2. The arrangement according to claim 1, wherein a voltage stabilization circuit is provided for a power supply for the fluxgate sensors.

3. The arrangement according to claim 1 or 2, wherein a low resistance reference voltage source connected is configured to be connected with the reference input of the differential amplifier for scaling the arrangement.

4. The device according to one of the preceding claims, wherein connection conductors between the fluxgate sensors and the input of the level adaptation circuit are provided shielded.

5. The arrangement according to one of the preceding claims, wherein the output signal is adjusted and calibrated to half of an operating voltage of the fluxgate sensors when no magnetic field is provided.

6. The arrangement according to claim 1, wherein the diode group is comprised of at least two diodes (D2, D3; D2, D4) connected anti-parallel.

## Revendications

1. Système pour le fonctionnement d'un appareil de localisation géophysique au moyen de l'évaluation de modifications du champ magnétique, comprenant une sonde et des capteurs de type "Flux-Gate", un circuit amplificateur et une unité d'évaluation et d'affichage, dans lequel :
- deux capteurs de type "Flux-Gate" écartés et orientés dans la même direction se trouvent dans la sonde, et les capteurs délivrent des tensions de sortie de la même polarité,
- les signaux de sortie sont amenés chacun à un circuit d'adaptation de niveau ainsi qu'à un circuit passe-bas,
- ces signaux parviennent, à la sortie des circuits passe-bas, à une entrée respective d'un amplificateur différentiel qui est connecté à l'entrée d'un amplificateur-limiteur,
- dans la branche de rétroaction de l'amplificateur-limiteur il est prévu un circuit parallèle formé d'une résistance et d'un groupe de diodes avec les diodes D1 à D4, et une rétroaction a lieu via les diodes D1 à D4 en liaison avec les résistances R2 et R4, de telle façon que des tensions de sortie plus faibles soient amplifiées plus fortement que des tensions plus fortes, et
- le signal d'évaluation se présente à la sortie de l'amplificateur-limiteur pour la poursuite de son traitement.

2. Système selon la revendication 1,
**caractérisé en ce qu'**il est prévu un circuit de stabilisation de tension pour l'alimentation électrique des capteurs "Flux-Gate".

3. Système selon la revendication 1 ou 2,
**caractérisé en ce que** pour la compensation du système, une source de tension de référence faiblement ohmique peut être connectée à l'entrée de référence de l'amplificateur différentiel.

4. Système selon l'une des revendications précédentes,
**caractérisé en ce que** les lignes de liaison entre les capteurs "Flux-Gate" et l'entrée du circuit d'adaptation de niveau sont réalisées blindées.

5. Système selon l'une des revendications précédentes,
**caractérisé en ce que**, en l'absence de champ magnétique, le signal de sortie est établi à la moitié de la tension de service des capteurs "Flux-Gate" et calibré.

6. Système selon la revendication 1,
**caractérisé en ce que** le groupe de diodes est formé par au moins deux diodes (D1, D3 ; D2, D4) branchées de manière antiparallèle.
